# EUROPÄISCHE PATENTSCHRIFT

(11) **EP 2 709 115 B1**
(45) Veröffentlichungstag und Bekanntmachung des Hinweises auf die Patenterteilung: **18.07.2018**
(21) Anmeldenummer: 13183162.0
(22) Anmeldetag: 05.09.2013
(51) Int. Cl.: H01C 1/082, H05K 7/20

(54) **Elektrischer Widerstand**
Electrical resistor
Résistance électrique

(30) Priorität: 13.09.2012 DE 102012108571
(43) Veröffentlichungstag der Anmeldung: 19.03.2014
(73) Patentinhaber: REO Inductive Components AG, 16866 Kyritz (DE)
(72) Erfinder: Reimann, Sven, 19322 Schadebeuster (DE)
(74) Vertreter: LS-MP von Puttkamer Berngruber Loth Spuhler

(56) Entgegenhaltungen:
- DE-A1- 4 210 979
- DE-A1- 10 313 355
- DE-A1- 19 545 447
- DE-C- 945 771
- DE-U1-202012 009 701

## Beschreibung

Die Erfindung betrifft einen elektrischen Widerstand mit den in Anspruch 1 definierten Merkmalen. Das Widerstandselement ist als Platine ausgebildet. Im Weiteren wird das Widerstandselement vereinfachend als Platine bezeichnet
Aus der DE 10 2010 040 582 A1 ist ein Gehäuse für eine elektronische Schaltung mit integrierter Kühlmittelpassage bekannt. Das Gehäuse weist eine Bodenplatte und eine Deckplatte auf. Die Kühlmittelpassage ist als Hohlraum in der durch Spritzgießen gefertigten Bodenplatte und/oder in der ebenfalls durch Spritzguss hergestellten Deckplatte realisiert. Aus der DE 195 45 447 A1 ist eine Bremswiderstand-Kühleinrichtung bekannt.

Wassergekühlte Widerstände, insbesondere Brems- und Belastungswiderstände gewinnen in der heutigen Kraftfahrzeug- sowie der Schienenfahrzeugindustrie immer größere Bedeutung. Wassergekühlte Widerstände können auch in anderen Industriezweigen Verwendung finden, wenn elektrische Motoren zum Antrieb von Haupt- und/oder Nebenaggregaten eingesetzt werden.

Bisher bekannte wassergekühlte Widerstände verfügen über eine vergleichsweise schlechte Wärmeverteilung und sind relativ aufwändig in der Herstellung. Es ist gängige Praxis, Kühlkanäle in Form von Rohrleitungen einzusetzen. Hierbei werden längs verlaufende Rohre mit quer verlaufenden Verbindungsrohren verschraubt, verklebt oder verlötet.

Diese Herstellungsart bedingt jedoch einen relativ hohen Fertigungsaufwand. Zusätzlich erweisen sich die Verbindungsstellen zwischen den längs- und/oder quer verlaufenden Rohrleitungen als Schwachstellen, da an diesen Stellen häufig Leckagen auftreten und Kühlflüssigkeit austritt. Gelangt die Kühlflüssigkeit in der Folge mit dem elektrischen Widerstand in Kontakt, so kann dies zu einer erheblichen Beschädigung des elektrischen Widerstands führen.

Zur Ausgestaltung der Kühlkanäle werden häufig Aluminiumrohre mit einem runden Durchmesser verwendet. Diese Kühlkanäle sind jedoch nur bis zu einer bestimmten Leistungsdichte einsetzbar. Im Stand der Technik bekannte wassergekühlte Brems- und Belastungswiderstände weisen darüber hinaus den Nachteil auf, dass eine gleichmäßige Wärmeabfuhr aus dem Widerstandskörper nur schwer realisierbar ist. Andere Bereiche des Widerstandskörpers sind auf Grund ihrer räumlichen Anordnung oder ihrer Gestaltung nur schwer kühlbar. Die Temperaturwerte an der Oberfläche des Widerstandskörpers verbleiben daher vergleichsweise relativ hoch. Auf Grund der bisher eingesetzten Technik zeichnen sich die Brems- und Belastungswiderstände in der Regel durch ein vergleichsweise hohes Eigengewicht und durch relativ hohe Herstellungskosten aus.

Auf Grund stetig steigender Leistungsdichten moderner Elektromotoren stellt sich jedoch auch an Einrichtungen zur Wasserkühlung gekühlter Brems- und/oder Belastungswiderständen die Anforderung, immer höhere Temperaturen flächendeckend und möglichst zeitnah vom Widerstandskörper abführen zu müssen.

Der Erfindung liegt somit die Aufgabe zu Grunde, einen wassergekühlten Widerstand, insbesondere Brems- und/oder Belastungswiderstand bereitzustellen, der ohne die vorgenannten Nachteile bekannter Widerstände funktioniert und zusätzlich bei einer gesteigerten Leistungsdichte optimierte Kühlwerte erbringt. Die Wärme soll gesamtflächig vom Widerstandskörper abgeführt werden, so dass die Betriebstemperatur an der Oberfläche des Widerstands deutlich herabgesenkt werden kann.

Eine weitere Aufgabe der Erfindung liegt darin, eine Einrichtung zur Kühlung eines Widerstands zu schaffen, die verbesserte Kühlwerte aufweist bei gleichzeitig geringerem Gewicht und konstruktiv einfacherem Aufbau. Ferner soll ein wassergekühlter Widerstand bereitgestellt werden, der anspruchsvollen Schutzartprüfungen bis zu IP 69 k genügt.

Der Aufbau und die Funktionsweise des erfindungsgemäßen Widerstands soll im Folgenden anhand eines wassergekühlten Brems- und/oder Belastungswiderstands beispielhaft dargestellt werden.

Der Widerstand umfasst dabei ein Widerstandselement d.h. eine Platine, an deren Oberflächen zu beiden Seiten je ein Kühlkörper angeordnet ist.

Der Kühlkörper umfasst eine Kühlplatte, die im verbauten Zustand mit einem Deckel verschlossen ist. Die Kühlplatte umfasst ihrerseits einen Rücken sowie an den Kanten des Rückens umlaufende Seitenwände. Zwischen der Platine und den an der Platine anliegenden Rücken der Kühlkörper ist jeweils eine Sand- und/oder Glimmerschicht aufgetragen.

Zur Abdichtung der Platine gegenüber dem Rücken der Kühlplatte des Kühlkörpers ist ein umlaufender Dichtungskörper vorgesehen. Weiter ist es denkbar, die Platine zur Abdichtung gegenüber dem Rücken der Kühlplatte mit diesem zu verkleben.

Im Sinn der vorliegenden Erfindung führt eine Wasserkühlung den zu kühlenden Oberflächen mithilfe von Kühlkanälen Kühlflüssigkeit zu. Die Kühlkanäle dienen dabei als Wärmetauscher, die die Oberflächentemperatur aufnehmen und von den zu kühlenden Oberflächen des Widerstandskörpers wegführen. Ein bedeutender Vorteil der Wasserkühlung gegenüber der Luftkühlung besteht z.B. in dem höheren Wärmeübergangskoeffizienten der Wasserkühlung gegenüber der Luftkühlung. Der Wasserübergangskoeffizient zwischen Luft und einem Festkörper ist um etwa dem Faktor 50 bis 100 niedriger, als der Wärmeübergangskoeffizient zwischen Wasser und einem Festkörper. Überdies erfordert die Luftkühlung eine wesentlich größere Kontaktfläche zwischen der zu kühlenden Oberfläche und dem Kühlungsmedium Luft. Weiterhin erfordert eine Luftkühlung im Vergleich zur Wasserkühlung wesentlich höhere Strömungsgeschwindigkeiten, die - technisch aufwendig - durch ein Kühlgebläse bereitgestellt werden müssen.

Statt Wassers kann auch eine andere Kühlflüssigkeit oder eine Mischung hieraus verwendet werden.

Im Zusammenhang mit der Erfindung bezeichnet der Widerstand ein zweipoliges, passives elektrisches Bauteil, das der Realisierung eines ohmschen Widerstands in elektrischen und elektronischen Schaltungen dient. Der Widerstand begrenzt den elektrischen Strom, teilt die elektrische Spannung in einer Schaltung auf und wandelt zusätzlich elektrische Energie in Wärmeenergie um.

Bremswiderstände dienen bei elektrischen Maschinen in der Regel gleichzeitig als Anfahrwiderstände, mit dem Zweck, zum Schutz eines elektrischen Fahrmotors während des Anfahrens zugeschaltet zu werden, um den Strom im Elektromotor auf ein erforderliches Maß zu begrenzen. Sobald der Elektromotor als elektromotorische Bremse arbeitet, schützt der Bremswiderstand den Elektromotor vor überhöhter Spannung durch Induktion. Gleichzeitig bewirkt der Strom eine Drehzahlverringerung des Elektromotors und erzielt damit eine Bremsung des Fahrzeugs.

Ein Belastungswiderstand liegt im DC-Stromkreis eines elektrischen Geräts oder eines elektrischen Bauteils und belastet das Quellgerät, welches an dem Eingang des Bauteils die Spannung liefert. In diesem Zusammenhang bezeichnet man die maximale Belastbarkeit des Widerstands als Nennlast. Es werden in ein gegossenes Werkstück Kühlkanäle eingebracht. Das Gusswerkstück kann aus einer Eisen-Kohlenstoff-Verbindung (Gusseisen oder Stahl) hergestellt sein. In gleicher Weise ist es möglich, nicht Eisenmetalle wie beispielsweise Kupfer, Blei, Zinn, Zink, Nickel in Reinform oder als Legierungen zu verwenden. Das Gusswerkstück kann jedoch auch in Leichtmetallform wie z.B. aus Aluminium, Magnesium oder Titan oder aus einer Legierung derselben hergestellt sein. Des Weiteren ist es denkbar, dass das Gusswerkstück aus anderen gießbaren Materialien, wie z.B. aus Kunststoff, hergestellt ist. Die vorausgehend genannten Werkstoffe sind jedoch in keiner Weise ausschließlich, sondern nur beispielhaft gemeint. Der Kühlkörper, insbesondere das mit Kühlkanälen versehene Werkstück ist ganz oder teilweise als Keramikbauteil ausgebildet.

Jeder Kühlkörper umfasst eine Kühlplatte, deren Rücken mit umlaufenden Seitenwänden als Gusswerkstück ausgebildet ist. Der Deckel, der die Kühlplatte abschließt, kann ebenfalls als Gussstück gearbeitet sein. An der Innenseite des Rückens der Kühlplatte, die dem Deckel zugewandt ist sind in das Gusswerkstück Kühlkanäle eingearbeitet. Die Kühlkanäle können z.B. durch Fräsen in das Gusswerkstück eingebracht sein. Außer durch Fräsen können die Kühlkanäle jedoch auch mit anderen technischen Möglichkeiten in das Gusswerkstück eingebracht sein. Da in einem Widerstandskörper wenigsten zwei Kühlplatten eingesetzt werden, kann der Montageaufwand erheblich reduziert werden.

Die Erfindung versteht unter Fräsen die spanabhebende Bearbeitung eines Metallwerkstücks mittels eines Fräswerkzeugs. Beim Fräsen wird die für die Spanabhebung erforderliche Schnittbewegung durch Rotation eines Schneidewerkzeugs gegenüber dem fest in einem Maschinentisch eingespannten Werkstück bewirkt.

Erfindungsgemäß kann vorgesehen sein, dass die Kühlkanäle in Reihe geschaltet sind. Zusätzlich ist es möglich, dass die Kühlkanäle parallel geschaltet werden.

Besonders bevorzugt verlaufen die Kühlkanäle mäandernd im Gusswerkstück, wobei sich die Kühlkanäle ausgehend von einer Kühlmittelzulaufbohrung zu einer Kühlmittelablaufbohrung erstrecken. Es ist vorgesehen, dass die Kühlmittelzuführung an der Kühlmittelzulaufbohrung und an der Kühlmittelablaufbohrung mittels eines Gewindes oder einer Schlauchtülle erfolgt, die am Gehäuse des Widerstandskörpers befestigt sind. Die Kühlkanäle weisen Streckenabschnitte auf, die achsparallel zu einander verlaufen und durch umleitende Verbindungsstücke miteinander kommunizieren. Weiter können die Kühlkanäle versetzt zu einander und in Reihe angeordnet sein und über ein Verbindungsstück aneinander gekoppelt werden.

Die Verbindungsstücke ermöglichen einen möglichst gleichförmigen und ungehinderten richtungsändernden Übergang von einem Streckenabschnitt des Kühlkanals zum benachbarten nächsten Streckenabschnitt. Gleichzeitig wird eine Optimierung der Strömungsgeschwindigkeit des Kühlmittels innerhalb der Kühlkanäle erreicht.

Erfindungsgemäß weisen die Kühlkanäle zur Vergrößerung ihres Durchmessers und ihrer Oberfläche einen unrunden Verlauf auf. Zusätzlich ist es denkbar, einen eckig-abgewinkelten Verlauf der Kühlkanäle vorzusehen. Zur Vergrößerung des Querschnitts des Kühlkanals ist in einer flachen Kanalausführung die Breite des Kühlkanals größer als die Höhe des Kühlkanals. Darüber hinaus kann ebenfalls zur Vergrößerung des Querschnitts des Kühlkanals die Höhe des Kühlkanals seine Breite überragen.

Eine bevorzugte Ausführungsform der Erfindung sieht weiter vor, dass die Kühlkanäle lamellenartige Rippen aufweisen, die in den Querschnitt der Kühlkanäle hineinragen. Darüber hinaus ist es möglich, zur Oberflächenvergrößerung Finnen oder sonstige Strömungsleitbleche im Kühlkanal vorzusehen. Die Kühlkanäle können ein rundes Profil, ein ovales Profil, ein mehreckiges Profil oder jede andere zweckdienliche Profilformung aufweisen.

An den jeweiligen Enden ihrer Länge gehen sie bevorzugt in gebogener Form in ihre Gegenrichtung über. Zusätzlich können die Kühlkanäle bevorzugt einen wellenförmigen Boden aufweisen. Zur Vergrößerung der Oberflächen der Kühlkanäle können die Kühlkanäle eine Wellenstruktur aufweisen. Die Wellen in Boden und Wandung der Kühlkanäle bewirken eine Verwirbelung innerhalb der Kühlflüssigkeit, die die Wärmeabfuhr zusätzlich begünstigt. Eine Verwirbelung innerhalb der Kühlflüssigkeit kann auch durch einen eckigen Verlauf des Kühlkanals hervorgerufen werden.

Weiterhin ist es denkbar, dass das Gusswerkstück ein Strangguss-Werkstück ist, in das die Kühlkanäle eingefräst sind.

Zum Verschließen der Kühlplatte des Kühlkörpers ist der Deckel vorgesehen, der mit der zugehörigen Kühlplatte verschweißt oder verklebt wird. Die vorgenannten Verbindungsformen sind nur rein exemplarisch und in keiner Weise ausschließlich gemeint.

Im verbauten Zustand weist der wassergekühlte Brems- und/oder Belastungswiderstand wenigstens zwei Übergänge auf, die jeweils in etwa rechtwinklig zu den Kühlmittelkanälen verlaufen und eine Strömungsverbindung zwischen dem Kühlkörper der einen Seite der Platine zum Kühlkörper auf der anderen Seite der Platine ermöglichen.

Kühlmittel strömt durch die Kühlmittelzulaufbohrung in das Innere der einen Kühlplatte ein. Durch die Kühlkanäle des einen Kühlkörpers fließt das Kühlmittel zu einem Übergang in den Kühlkörper auf der anderen Seite der Platine. Aus dem letztgenannten Kühlkörper wird das Kühlmittel durch eine Kühlmittelablaufbohrung, einem Kühlmittelreservat zugeführt.

Die Kühlkanäle können in Mäander-Form, in Schlangenlinien, spiralförmig oder in Form einer Ellipse oder in einer anderen geometrischen Form verlaufen. Zum Zweck der möglichst flächendeckenden Kühlung der Platine können die Kühlkanäle auch in anderer Form in der Kühlplatte angeordnet und in anderer Weise in die Kühlplatte eingebracht werden. Die Kühlkanäle können auch mehrstöckig angeordnet sein.

Ein Übergang zwischen den jeweiligen Kühlkörpern gewährleistet, dass die Kühlflüssigkeit beide Seiten der Platine kühlt. In gleicher Weise wird gewährleistet, dass auf beiden Seiten der Platine flächendeckend und lokal an sogenannten Hot-Spots Wärme aus dem Widerstandskörper abgeführt werden kann.

In einer anderen bevorzugten Variante der Erfindung umfasst der Kühlkörper einen Werkstoff besonders hoher Wärmeleitfähigkeit. Eine Verbesserung der Wärmeleitung bei gegossenen Kühlkörpern ist z.B. durch Einsatz von Eisenoxiden wie z.B. Aluminiumoxid oder zusätzlich durch Verguss mittels Hochtemperaturmassen möglich.

Das Widerstandsgehäuse, das die beiden miteinander verbundenen Kühlkörper und die zwischen den Kühlkörpern angeordnete Platine umfasst, erfordert keine zusätzlichen funktionellen Anbauten außerhalb des Widerstandsgehäuses. Die kompakte Form des erfindungsgemäßen Widerstands ermöglicht eine platzsparende Verbauung z.B. innerhalb eines Fahrzeugs aber auch in Maschinen und erweist sich überdies als leicht stapelbar und somit einfach zu transportieren.

Zur Stromversorgung können z.B. an der Stirnseite des Widerstandskörpers Steckbuchsen und/oder Steckverbindungen angeordnet sein, die in eine Anschlusskammer einmünden, die die Bauteile und Anschlüsse umfasst, die der Anbindung des Widerstands an den Stromkreislauf dienen. Es sind wenigstens drei Dichtungskörper erforderlich, wobei ein erster Dichtungskörper die umlaufende Dichtung ist, die die Platine gegenüber den an der Platine anliegenden Kühlkörpern abdichtet. Die wenigstens zwei weiteren Dichtungskörper sind im Bereich des Kühlmittelzulaufs und des Kühlmittelablaufs angeordnet und dienen der Abdichtung der Platine gegenüber der Kühlmittelflüssigkeit, die den Kühlmittelzulauf und/oder den Kühlmittelablauf durchströmt. Anstelle der Dichtkörper können auch andere funktionsdienliche Dichtungseinrichtungen oder auch flüssige Dichtmassen Verwendung finden.

Die Erfindung erweist sich als vorteilhaft, da sich durch eine äußerst kompakte Bauweise ein sehr geringes Gewicht des Widerstandskörpers realisieren lässt. Gleichzeitig erfüllt der erfindungsgemäße Widerstand die Anforderungen hoher Schutzarten wie z.B. IP 69 k. Erfindungsgemäß umfasst der Widerstandskörper wenigstens zwei Kühlkörper.

Es ist eine umlaufende Seitenwand vorgesehen, die sich entlang der Außenkanten der Kühlplatte erstreckt. Die umlaufende Seitenwand erhebt sich auf der von der Platine abgewandten Seite der Kühlplatte in etwa rechtwinklig zur Kühlplatte und trägt im verbauten Zustand den Deckel, der den Kühlkörper nach außen abschließt. Mit der vom Deckel abgewandten Seite des Rückens der Kühlplatte liegt der Kühlkörper an einer Seitenwand der Platine an. Zwischen der Seitenwand der Platine und dem Rücken der Kühlplatte erstreckt sich dabei eine Schicht aus Glimmer und/oder Sand. An jeder Seitenwand der Platine kann wenigstens eine Kühlplatte angeordnet sein.

Damit Kondenswasser, das sich im Bereich der Platine bildet aus dem Widerstandsgehäuse heraus diffundieren kann, ist am Widerstandsgehäuse vorzugsweise eine Membran vorgesehen. Die Membran kann in eine Richtung oder in beiden Richtungen durchlässig sein. Es ist vorstellbar, an mehr als einer Stelle am Widerstandsgehäuse eine Membran anzuordnen. Die Membran kann aus wenigstens einem Material gefertigt sein, das ein Diffundieren von Kondenswasser aus dem Widerstandsgehäuse nach außen begünstigt. Es wird ein Kühlkörper bereitgestellt, der eine Anschlusskammer umfasst, in der Einrichtungen angeordnet sein können, die der Stromversorgung des Widerstandskörpers und/oder der Platine dienen.

Der Kühlkörper umfasst weiter eine Platinenkammer, in die die Platine aufgenommen ist. Die Kühlkörper des Widerstandskörpers umfassen mindestens je eine Anschlusskammer und mindestens je eine Platinenkammer, wobei die Kühlkörper so ausgebildet sind, dass im zusammengebauten Zustand die Anschlusskammern bzw. die Platinenkammern der jeweiligen Kühlkörper einander gegenüber liegen.

Zur Optimierung der Wärmeübertragung vom Kühlkörper auf das Kühlmittel kann die Oberflächeneigenschaft der Kühlkanäle durch eine Oberflächenbehandlung optimiert werden.

Zur Beschichtung der Oberflächen der Kühlkanäle kann Nanotechnologie eingesetzt werden. Nanokörper verhalten sich dabei nicht mehr wie amorphe Substanzen, sondern nehmen vielmehr die Eigenschaften des Kühlmittels (z.B. Kühlflüssigkeit) an.

Vorzugsweise sind die Kühlkanäle in die Oberfläche eines Werkstücks eingearbeitet sind und durch einen Deckel abgedeckt.

Nach einer weiteren bevorzugten Ausführungsform der Erfindung sind die Kühlkanäle in einen Alu-Guss-Körper eingearbeitet.

Eine Vergrößerung des Durchmessers der Kühlkanäle im Gusswerkstück führt zu einer Erhöhung des Durchsatzes an Kühlmittel im Kühlkanal. Eine daraus folgende erhöhte Wärmeaufnahmekapazität führt weiter zu einer flächendeckenden Verbesserung der Kühlung im Widerstandskörper.

Der Begriff Gusswerkstück umfasst dabei den gesamten Kühlkörper mit Kühlplatte, umlaufender Seitenwand und Deckel.

Rechteckförmige oder mehreckförmige Kühlkanäle, die in das Gusswerkstück des Kühlkörpers eingefräst sind, erhöhen die Wärmeaufnahmekapazität des Kühlmittels gegenüber dem Einsatz von Kühlrohren aus Aluminium, die bisher als Kühlkanäle eingesetzt wurden.

Die Einbringung von Kühlkanälen in das Gusswerkstück des Widerstandskörpers reduziert die Gefahr, dass sich insbesondere an Verbindungsstellen zwischen zwei Kühlrohren Leckagen bilden. Eine Undichtigkeit innerhalb des Kühlkanals führt zu einem fortschreitenden Verlust an Kühlmittel und weiter zu Druckverlust innerhalb des Kühlkanals. Ein Druckabfall im Kühlkanal führt weiter zu einer Verringerung der Kühlung innerhalb des Widerstandskörpers, wodurch eine Beschädigung des Widerstands erfolgen kann.

Ein weiterer Vorteil der Erfindung liegt darin, dass die Fertigstellung und der Einbau des Widerstandskörpers nur noch ein Minimum an Blindschrauben und vergleichsweise wenige Anschlüsse erfordert. Die kompakte Bauweise des Widerstandskörpers ermöglicht eine einfache gegenseitige Anbindung, so dass mehrere Widerstandskörper seriell oder parallel hintereinander geschaltet werden können, ohne das eine räumliche Anordnung der Widerstandskörper nebeneinander zu einer Überhitzung eines einzelnen Widerstandskörpers führen würde.

Die Platine des Widerstandskörpers kann zur elektrischen Isolation gegen den Kühlkörper in einer Schicht aus Glimmer und/oder Sand eingebettet sein. Hierdurch wird eine kompakte Bauweise und eine einfache Fertigung begünstigt.

Eine elektrische Isolation kann darüber hinaus durch Verwendung eines besonderen Plattenmaterials und/oder durch Verguss erfolgen. Der Widerstand ist erfindungsgemäß als Wickelgut, und/oder als Plattenwiderstand ausgebildet, wobei der Plattenwiderstand Widerstandsmaterialien umfasst.

Die Erfindung wird nachfolgend anhand von Ausführungsbeispielen mit Hilfe von Figuren näher erläutert.
- Fig. 1:: zeigt einen Widerstandskörper nach dem Stand der Technik,
- Fig. 2.:: zeigt eine Wärmeverteilung eines nach dem Stand der Technik gekühltem Widerstands,
- Fig. 3:: zeigt eine Wärmeverteilung mit einem erfindungsgemäßen wassergekühlten Widerstand,
- Fig. 4:: zeigt ebenfalls die Wärmeverteilung eines erfindungsgemäß wassergekühlten Widerstandskörpers,
- Fig. 5:: zeigt den erfindungsgemäßen Widerstand in perspektivischer Darstellung und
- Fig. 6:: zeigt einen Kühlkörper mit Kühlkanälen.

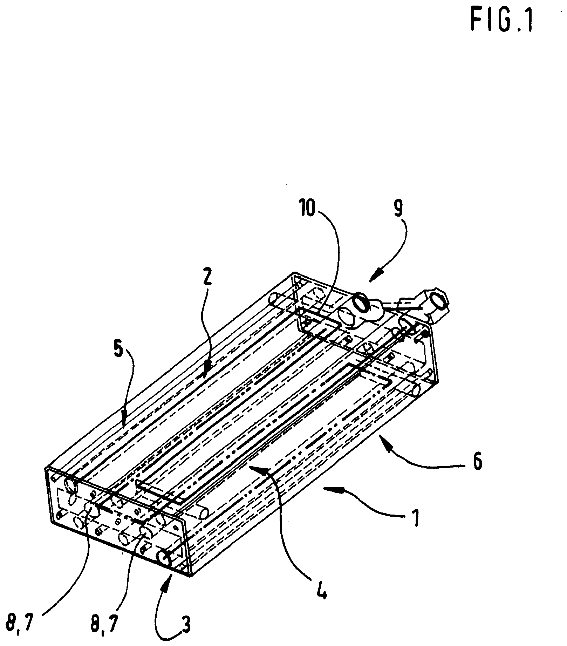

Fig. 1 zeigt einen Widerstandskörper 1 aus dem Stand der Technik mit oberen 2 und unteren 3 Seitenwänden, die über eine seitliche Wand mit einander verbunden sind. Der Widerstandskörper 1 ist in perspektivischer Darstellung gezeigt und weist voneinander beabstandete Kühlkörper 5; 6 auf, in denen sich achsparallel zueinander verlaufende Kühlkanäle 7 erstrecken. Die Kühlkanäle 7 sind als Aluminiumrohre dargestellt, die jeweils einen runden Querschnitt 8 aufweisen. Im Bereich der Stirnseiten 9 sind die Kühlkanäle 7 durch nicht dargestellte, quer verlaufende Kühlkanäle 10 mit einander verbunden. Die querverlaufenden Kühlkanäle 10 sind mit den entlang der Längsachse des Widerstandskörpers verlaufenden Kühlkanälen 7 verschweißt, verklebt oder in einer anderen Weise befestigt.

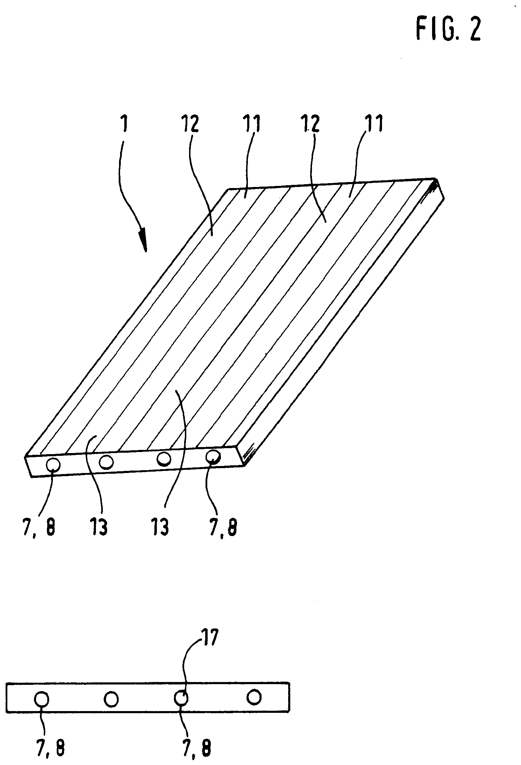

Fig. 2 zeigt die Wärmeverteilung eines herkömmlich gekühlten Widerstandskörpers 1. In den Widerstandskörper 1 sind Kühlkanäle 7 eingebettet, die einen runden Querschnitt 8 aufweisen und in etwa achsparallel zur Längsachse des Widerstandskörpers 1 verlaufen. In den Bereichen, in denen die Kühlkanäle 7 in den Widerstandskörper 1 eingebettet sind, liegen die Bereiche 11 niedriger Temperatur. Die Bereiche gehen zu beiden Seiten in Bereiche 12 über, die erhöhte Temperaturwerte ausweisen. Zwischen den Bereichen 11 des Widerstandskörpers 1, die durch die Kühlkanäle 7 auf niedrige Temperaturwerte herabgekühlt sind verlaufen Bereiche 13, in denen der Widerstandskörper 1 nahezu ungekühlt ist.

Aus Fig. 2 ist ersichtlich, dass die Kühlung des Widerstandskörpers 1 nach dem hier gezeigten Stand der Technik weite Bereiche 11 des Widerstandskörpers 1 nahezu ungekühlt lässt. Benachbarte Bereiche 12 weisen dagegen sehr niedrige Temperaturwerte auf. Die hohen Temperaturdifferenzen innerhalb des Widerstandskörpers 1 aus dem Stand der Technik können zur Beschädigung des Widerstandskörpers 1 oder seiner Bestandteile führen.

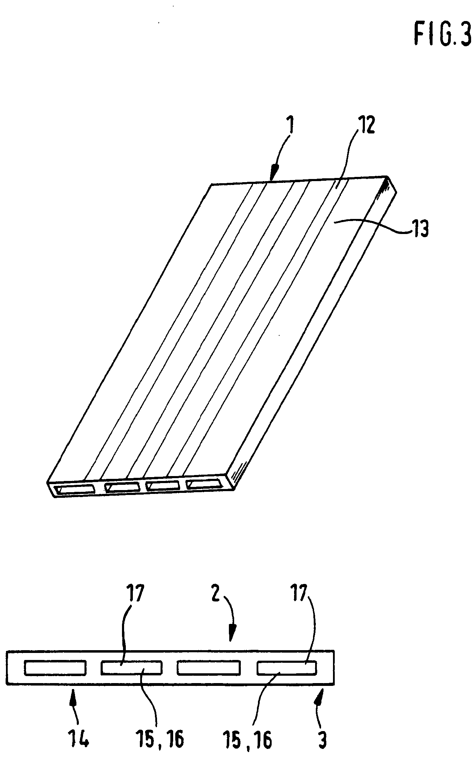

In Fig. 3 ist eine Temperaturverteilung eines Widerstandskörpers 1 gezeigt, der mit Hilfe der erfindungsgemäßen Kühlkörper 14 abgekühlt wird. Die in Fig. 3 verwendeten Kühlkanäle 15 weisen einen rechteckigen Querschnitt 16 auf, der im Vergleich zum runden Querschnitt 8 des Kühlkanals 7 aus Fig. 2 einen wesentlich höheren Durchsatz an Kühlflüssigkeit 17 ermöglicht. In Fig. 3 sind die Temperaturunterschiede innerhalb des Widerstandskörpers 1 wesentlich geringer, da im Bereich der oberen/unteren Seitenwand 2; drei nur noch Bereiche 12 mittlere Temperaturwerte und Bereiche 13 hohe Temperaturwerte erkennbar sind.

Die Gefahr, dass der Widerstandskörper 1 durch hohe Temperaturdifferenzen zwischen Bereichen 11 niedriger Temperatur und Bereichen 13 hoher Temperatur beschädigt wird, kann auf diese Weise wirksam verhindert werden. Aus den Figuren 2 und 3 ist zu erkennen, dass die gleichmäßigere Temperaturverteilung innerhalb des Widerstandskörpers 1 auf den geänderten Querschnitt des Kühlkanals 7; 15 zurückzuführen ist. In Fig. 2 erfolgt die Kühlung des Widerstandskörpers über vier Kühlkanäle 7 mit rundem Querschnitt 8, wogegen zur Kühlung des Widerstandskörpers 1 erfindungsgemäß in Fig. 3 Kühlkanäle 15 mit rechteckigem Querschnitt 16 verwendet werden.

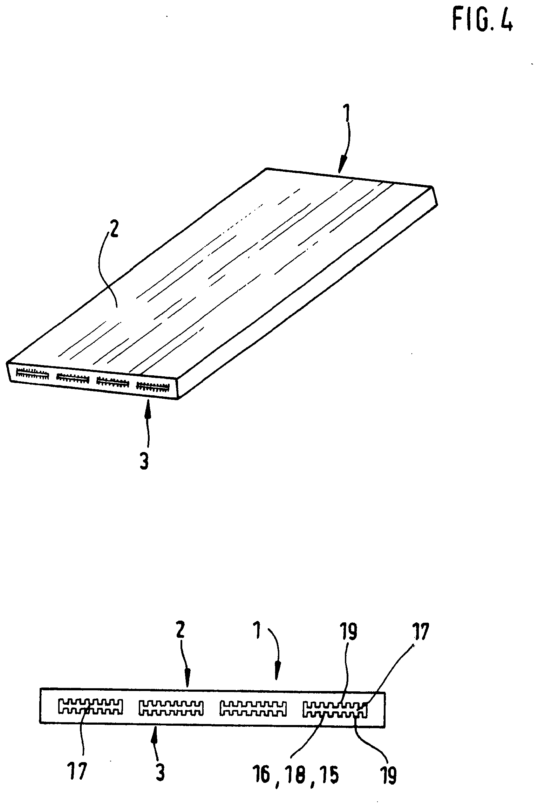

Fig. 4 zeigt die Wärmeverteilung auf der oberen bzw. unteren Seitenwand 2; 3 des Widerstandskörpers 1. In Fig. 4 wird die Oberfläche 18 des rechteckigen Querschnitts 16 des Kühlkanals 15 durch Einbringung zusätzlicher Lamellen 19 vergrößert. Die Wärmeübertragung vom Widerstandskörper 1 auf das Kühlmittel 17 kann auf diese Weise erheblich gesteigert werden.

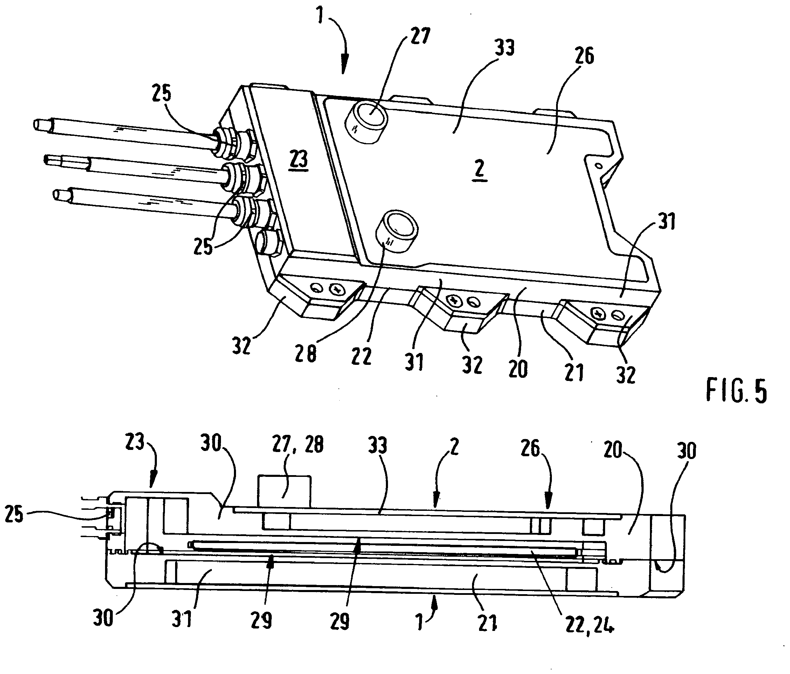

Fig. 5 zeigt in perspektivischer Darstellung den Widerstandskörper 1 mit einem oberen Kühlkörper 20 sowie einem unteren Kühlkörper 21. Zwischen den beiden Kühlkörpern 20; 21 ist eine Platine 22 des Widerstands 24 dargestellt. An der oberen Seitenwand 2 des Widerstandskörpers 1 ist eine Anschlusskammer 23 gezeigt, die die elektrischen Einrichtungen des Widerstands 24 umfasst.

An der Stirnseite des Widerstandskörpers 1 sind Steckbuchsen bzw. Steckverbindungen 25 dargestellt. Ebenfalls an der oberen Seitenwand 2, benachbart zur Anschlusskammer 23 ist die Platinenkammer 26 erkennbar, in deren Bereich die Platine 22 des Widerstands 24 angeordnet ist. Auf der Oberseite 2 der Platinenkammer 26 ragen je eine Kühlmittelzulaufbohrung 27 und eine Kühlmittelablaufbohrung 28 aus der Platinenkammer 26 heraus. Im verbauten Zustand des Widerstandskörpers 1 erfolgt die Zuleitung des Kühlmittels 17 durch die Kühlmittelzulaufbohrung 27. Nach Durchströmung der Kühlkanäle 15 wird das Kühlmittel 17 durch die Kühlmittelablaufbohrung 28 einem nicht dargestellten Kühlmittelreservoir zugeführt.

Der Widerstandskörper 1 umfasst die Platine 22 (nicht dargestellt), die wenigstens je eine obere und eine untere Seitenfläche aufweist. An wenigstens einer Seitenfläche der Platine 22 liegt wenigstens ein Kühlkörper an. Zwischen der Seitenfläche der Platine und dem Kühlkörper ist eine Schicht 29 aus Sand bzw. Glimmer angeordnet, die zur elektrischen Isolation der Platine 22 vorgesehen ist. Der Kühlkörper 20; 21 umfasst einen Rücken 30 sowie umlaufende Seitenwände 31.

Die Nasen und Verbindungselemente 32, die am Kühlkörper 20; 21 angeordnet sind dienen der Verbindung der einander gegenüberliegenden Kühlkörper 20; 21 mit einander. Gleichzeitig dienen sie der Befestigung des Widerstandskörpers 1 an einer nicht gezeigten Basis z.B. eines Elektromotors.

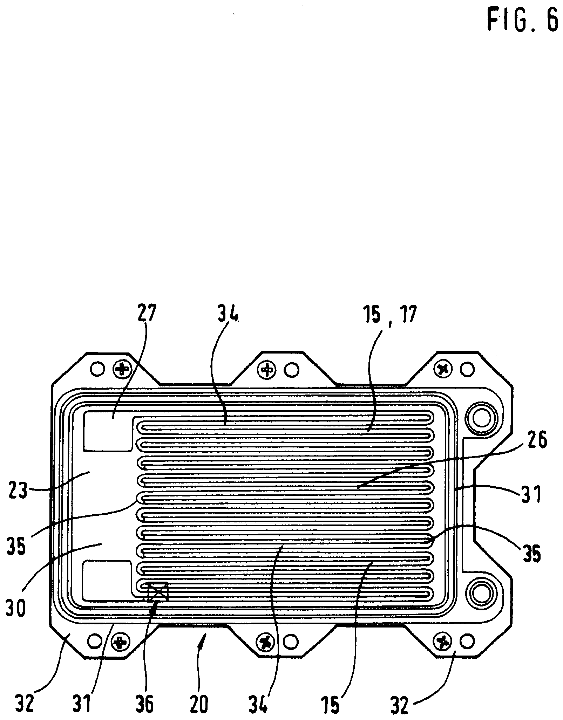

Fig. 6 zeigt in Draufsicht den Kühlkörper 20; 21 ohne Deckel 23 (Fig. 5), mit Blick auf die Kühlkanäle 15. Am Außenumfang des Kühlkörpers 20; 21 ist die umlaufende Seitenwand 31 des Kühlkörpers 20; 21 erkennbar. Im verbauten Zustand liegt der Deckel 33 (nicht dargestellt) auf der umlaufenden Seitenwand 31 auf und schließt den Kühlkörper 20; 21 dichtend ab. Auf seiner von der Platine 22 abgewandten Seite sind in den Rücken 30 des Kühlkörpers 20; 21 Kühlkanäle 15 eingearbeitet. In Fig. 6 verlaufen die Kühlkanäle 15 in etwa achsparallel zueinander, wobei die Umlenkung des Verlaufs der geradlinigen Streckenabschnitte 34 der Kühlkanäle 15 durch Verbindungsstücke 35 bewirkt wird. Die meanderförmige Anordnung der Kühlkanäle 15 ermöglicht eine flächendeckende Kühlung der anliegenden Platine 22 des Widerstandskörpers 1. Die Kühlkanäle 15 erstrecken sich im Bereich der Platinenkammer 26, wobei die elektrischen Anschlüsse 25 der Platine 22 im Bereich der Anschlusskammer 23 des Widerstandskörpers 21 angeordnet sind.

Mit Bezugsziffer 27 ist die Kühlmittelzulaufbohrung dargestellt, über die das Kühlmittel 17 in die Kühlkanäle 15 eingespeist wird. Nach Durchströmung der Kühlkanäle 15 im Kühlkörper 20; 21 gelangt das Kühlmittel 17 durch einen Übergang 36 in den Kühlkörper 21, der auf der gegenüberliegenden Seite der Platine 22 angeordnet ist. Nach Durchströmung der Kühlkanäle 15 des gegenüberliegenden Kühlkörpers 21 wird das Kühlmittel 17 durch die Kühlmittelablaufbohrung einem nicht dargestellten Kühlmittelreservoir zugeführt.

Die Platine 22 wird durch einen umlaufenden Dichtungskörper (Fig. D) gegenüber dem Kühlkörper 20; 21 abgedichtet. Weitere Dichtungskörper 37 sind im Bereich der Kühlmittelzulaufbohrung 27 bzw. der Kühlmittelablaufbohrung 28 angeordnet.

In Draufsicht auf den Kühlkörper 20; 21 sind die Nasen bzw. die Verbindungselemente 32 dargestellt, mit denen die beiden Kühlkörper 20; 21 aneinander befestigt werden können bzw. mit denen der Widerstandskörper 1 an einer nicht gezeigten Basis z.B. angeschraubt werden kann.

### Bezugszeichenliste

- 1: Widerstandskörper
- 2: obere Seitenwand
- 3: untere Seitenwand
- 4: seitliche Wand
- 5: Kühlkörper
- 6: Kühlkörper
- 7: Kühlkanal
- 8: runder Querschnitt
- 9: Stirnseite
- 10: Kühlkanal quer
- 11: Bereich mit niedriger Temperatur
- 12: Bereich mit erhöhter Temperatur
- 13: ungekühlter Bereich
- 14: Kühlkörper
- 15: Kühlkanal
- 16: rechteckiger Querschnitt
- 17: Kühlflüssigkeit
- 18: Oberfläche des rechteckigen Querschnitts
- 19: Lamellen
- 20: oberer Kühlkörper
- 21: unterer Kühlkörper
- 22: Platine
- 23: Anschlusskammer
- 24: Widerstand
- 25: Steckbuchse bzw. Steckverbindung
- 26: Platinenkammer
- 27: Kühlmittelzulaufbohrung
- 28: Kühlmittelablaufbohrung
- 29: Schicht aus Sand bzw. Glimmer
- 30: Rücken
- 31: Seitenwand
- 32: Verbindungselement
- 33: Deckel
- 34: geradliniger Streckenabschnitt
- 35: Verbindungsstücke

## Patentansprüche

1. Elektrischer Widerstand mit einem, in einem Widerstandskörper (1) angeordneten Widerstandselement (22) bei der das Widerstandselement (22) eine Platine ist, und mit einer Kühleinrichtung, die so ausgestaltet ist, dass Kühlflüssigkeit (17) Kühlkanäle (15) von gegen die Platine elektrisch isolierten Kühlkörpern (20; 21) durchströmt, wobei die Kühlkanäle (15) einen unrunden Querschnitt und einen flächendeckenden Verlauf durch die Kühlkörper (20; 21) aufweisen, wobei der eine Kühlkörper (20) ein oberer Kühlkörper ist und der andere Kühlkörper (21) ein unterer Kühlkörper ist und zwischen beiden Kühlkörpern das Widerstandselement (22) angeordnet ist und der elektrische Widerstand so ausgestaltet ist, dass die Kühlflüssigkeit (17) die Kühlkanäle (15) durchströmt und von einem Kühlkörper (20, 21; 21, 20) durch einen Übergang (36) in den anderen Kühlkörper (20, 21; 21, 20), der auf der gegenüberliegenden Seite des Widerstandselements (22) angeordnet ist, gelangt.

2. Elektrischer Widerstand nach Anspruch 1, **dadurch gekennzeichnet, dass** die Kühlkanäle (15) einen abgewinkelten Verlauf aufweisen.

3. Elektrischer Widerstand nach Anspruch 1, **dadurch gekennzeichnet, dass** die Kühlkanäle (15) lamellenartige Rippen (19) aufweisen, die in den Querschnitt der Kühlkanäle (15) hineinragen.

4. Elektrischer Widerstand, nach einem oder mehreren der vorhergehenden Ansprüche, **dadurch gekennzeichnet, dass** die Kühlkanäle (15) einen wellenförmigen Boden aufweisen.

5. Elektrischer Widerstand nach einem oder mehreren der vorhergehenden Ansprüche, **dadurch gekennzeichnet, dass** die Kühlkanäle (15) eine wellförmige Wandung aufweisen.

6. Elektrischer Widerstand nach einem oder mehreren der vorhergehenden Ansprüche, **dadurch gekennzeichnet, dass** die Kühlkanäle (15) in ein Werkstück eingearbeitet sind und durch einen Deckel (33) abgedeckt sind.

7. Elektrischer Widerstand nach Anspruch 6, **dadurch gekennzeichnet, dass** die Kühlkanäle (15) in einen Alu-Guss-Körper (20; 21) eingearbeitet sind.

8. Elektrischer Widerstand nach einem der vorhergehenden Ansprüche, **dadurch gekennzeichnet, dass** die beiden miteinander verbundenen Kühlkörper (20, 21) und das zwischen den Kühlkörpern (20, 21) angeordnete Widerstandselement (22) von einem Widerstandsgehäuse umfasst werden und das Widerstandsgehäuse zur Abführung von Kondenswasser eine Membran aufweist.

9. Elektrischer Widerstand nach einem oder mehreren der vorgehenden Ansprüche, **dadurch gekennzeichnet, dass** der Kühlkörper (20; 21) einen Werkstoff besonders hoher Wärmeleitfähigkeit umfasst.

10. Elektrischer Widerstand nach einem oder mehreren der vorhergehenden Ansprüche, **dadurch gekennzeichnet, dass** die Kühlkanäle (15) in Reihe geschaltet sind.

## Claims

1. Electrical resistor having a resistor element (22) arranged in a resistor body (1), wherein the resistor element (22) is a printed circuit board, and having a cooling device, which is configured in such a way that a cooling liquid (17) flows through cooling channels (15) of heat sinks (20; 21) electrically insulated against the printed circuit board, wherein the cooling channels (15) have a non-circular cross section and a surface-covering course through the heat sinks (20; 21), wherein one heat sink (20) is an upper heat sink and the other heat sink (21) is a lower heat sink and the resistor element (22) is arranged between both heat sinks and the electrical resistor is configured in such a way that the cooling liquid (17) flows through the cooling channels (15) and is passed from one heat sink (20, 21; 21, 20) through a passage (36) into the other heat sink (20, 21; 21, 20), which is arranged on the opposite side of the resistor element (22).

2. Electrical resistor according to claim 1, **characterized in that** the cooling channels (15) have an angled course.

3. Electrical resistor according to claim 1, **characterized in that** the cooling channels (15) have lamellar ribs (19), which project into the cross section of the cooling channels (15).

4. Electrical resistor, according to one or more of the preceding claims, **characterized in that** the cooling channels (15) have a wave-shaped bottom.

5. Electrical resistor according to one or more of the preceding claims, **characterized in that** the cooling channels (15) have a wave-shaped wall.

6. Electrical resistor according to one or more of the preceding claims, **characterized in that** the cooling channels (15) are incorporated into a workpiece and are covered by a cover (33).

7. Electrical resistor according to claim 6, **characterized in that** the cooling channels (15) are incorporated into a cast aluminium body (20; 21).

8. Electrical resistor according to any of the preceding claims, **characterized in that** the two heat sinks (20, 21) connected to each other and the resistor element (22) arranged between the heat sinks (20, 21) are enclosed by a resistor housing and the resistor housing has a membrane for draining off condensation water.

9. Electrical resistor according to one or more of the preceding claims, **characterized in that** the heat sink (20; 21) comprises a material of especially high thermal conductivity.

10. Electrical resistor according to one or more of the preceding claims, **characterized in that** the cooling channels (15) are connected in series.

## Revendications

1. Résistance électrique comportant un élément de résistance (22) agencé dans un corps de résistance (1), dans laquelle l'élément de résistance (22) est une platine, et comportant un dispositif de refroidissement qui est réalisé de telle sorte que du liquide de refroidissement (17) passe à travers des canaux de refroidissement (15) de corps de refroidissement (20 ; 21) électriquement isolés de la platine, les canaux de refroidissement (15) présentant une section transversale non circulaire et un parcours complet à travers les corps de refroidissement (20 ; 21), ledit un corps de refroidissement (20) étant un corps de refroidissement supérieur et l'autre corps de refroidissement (21) étant un corps de refroidissement inférieur, et entre les deux corps de refroidissement étant agencé l'élément de résistance (22), et la résistance électrique étant réalisée de telle sorte que le liquide de refroidissement (17) passe à travers les canaux de refroidissement (15) et parvient depuis un corps de refroidissement (20, 21 ; 21, 20) par un passage (36) dans l'autre corps de refroidissement (20, 21 ; 21, 20) qui est agencé sur le côté opposé de l'élément de résistance (22).

2. Résistance électrique selon la revendication 1, **caractérisée en ce que** les canaux de refroidissement (15) présentent un parcours coudé.

3. Résistance électrique selon la revendication 1, **caractérisée en ce que** les canaux de refroidissement (15) présentent des nervures (19) en forme de lamelles qui font saillie dans la section transversale des canaux de refroidissement (15).

4. Résistance électrique selon l'une ou plusieurs des revendications précédentes, **caractérisée en ce que** les canaux de refroidissement (15) présentent un fond ondulé.

5. Résistance électrique selon l'une ou plusieurs des revendications précédentes, **caractérisée en ce que** les canaux de refroidissement (15) présentent une paroi ondulée.

6. Résistance électrique selon l'une ou plusieurs des revendications précédentes, **caractérisée en ce que** les canaux de refroidissement (15) sont incorporés dans une pièce à usiner et recouverts d'un couvercle (33).

7. Résistance électrique selon la revendication 6, **caractérisée en ce que** les canaux de refroidissement (15) sont incorporés dans un corps en fonte d'aluminium (20 ; 21).

8. Résistance électrique selon l'une ou plusieurs des revendications précédentes, **caractérisée en ce que** les deux corps de refroidissement (20, 21) reliés l'un à l'autre et l'élément de résistance (22) agencé entre les corps de refroidissement (20, 21) sont entourés par un boîtier de résistance et **en ce que** le boîtier de résistance présente une membrane pour l'évacuation d'eau de condensation.

9. Résistance électrique selon l'une ou plusieurs des revendications précédentes, **caractérisée en ce que** le corps de refroidissement (20, 21) comprend un matériau à haute conductivité thermique.

10. Résistance électrique selon l'une ou plusieurs des revendications précédentes, **caractérisée en ce que** les canaux de refroidissement (15) sont montés en série.
